# EUROPEAN PATENT APPLICATION

(11) **EP 1 858 068 A2**
(43) Date of publication of application: **21.11.2007**
(21) Application number: 07252057.0
(22) Date of filing: 18.05.2007
(51) Int. Cl.: H01L 21/336

(54) **Method of fabricating a thin film transistor**

(30) Priority: 18.05.2006 KR 20060044814
(71) Applicant: Samsung SDI Co., Ltd., Suwon-si, Gyeonggi-do (KR)
(72) Inventor: Yang, Tae-Hoon c/o Samsung SDI Co., Ltd., Gyeonggi-do (KR); Lee, Ki-Yong c/o Samsung SDI Co., Ltd., Gyeonggi-do (KR); Seo, Jin-Wook c/o Samsung SDI Co., Ltd., Gyeonggi-do (KR); Park, Byoung-Keon c/o Samsung SDI Co., Ltd., Gyeonggi-do (KR)
(74) Representative: Mounteney, Simon James

(57) **Abstract**

A method of fabricating a thin film transistor (TFT) includes: performing a first annealing process on a substrate to diffuse a metal catalyst through a capping layer into a surface of an amorphous silicon layer, and to crystallize the amorphous silicon layer to a polycrystalline silicon layer due to the diffused metal catalyst; removing the capping layer; patterning the polycrystalline silicon layer to form a semiconductor layer; forming a gate insulating layer and a gate electrode on the substrate; implanting first impurity ions into the semiconductor layer; and implanting a gettering material into the semiconductor layer and performing a second annealing process to remove the metal catalyst. Herein, the first impurity ions may be p-type impurity ions and the p-type impurity ions may be implanted at a dose of 6x10¹³/cm² to 5x10¹⁵/cm², and the gettering material is implanted at a dose of 1x10¹¹/cm² to 3x10¹⁵/cm² to form a p-type TFT.

## Description

### BACKGROUND OF THE INVENTION

### 1. Field of the Invention

The present invention relates to a method of fabricating a thin film transistor (TFT). More particularly, the present invention relate to a method of fabricating a p-type (PMOS) TFT that includes crystallizing an amorphous silicon (a-Si) layer into a polycrystalline silicon (poly-Si) layer.

### 2. Description of the Related Art

In general, a poly-Si layer is widely used as a semiconductor layer for a thin film transistor (TFT) because a poly-Si layer has high-field effect mobility, is applicable to a high-speed operation circuit, and implements a CMOS circuit configuration. A TFT with a poly-Si layer is primarily used as an active device of an active matrix liquid crystal display (AMLCD), and a switching device and a driving device of an organic light emitting display (OLED).

The crystallization of an a-Si layer into a poly-Si layer may be performed using a solid phase crystallization (SPC) method, an excimer laser crystallization (ELC) method, a metal induced crystallization (MIC) method, or a metal induced lateral crystallization (MILC) method. Specifically, the SPC method involves annealing an a-Si layer for several hours to several tens of hours at a temperature lower than about 700 °C at which a substrate, such as glass, forming a material for a display device using a TFT is deformed. In the ELC method, an a-Si layer is irradiated with an excimer laser beam until the a-Si layer is locally heated to a high temperature for a short amount of time to crystallize the a-Si layer into a poly-Si layer. The MIC method induces a phase change of an a-Si layer into a poly-Si layer by bringing a metal, such as nickel (Ni), palladium (Pd), gold (Au), and aluminum (Al), into contact with the a-Si layer (or injecting the metal into the a-Si layer). Also, the MILC method induces lateral, sequential crystallization by reacting the metal with silicon to form a silicide.

Nevertheless, the above methods have drawbacks in that the SPC method takes much time and needs a high-temperature annealing process to be performed for a long time so that the substrate is susceptible to deformation. The ELC method not only requires an expensive laser apparatus, but also causes formation of polycrystalline protrusions, and deteriorates an interfacial characteristic between a semiconductor layer and a gate insulating layer. In the MIC and MILC methods, a large amount of metal catalyst remains in a poly-Si layer, resulting in an increase in a leakage current in a semiconductor layer of a TFT.

In recent years, there have been intensive studies on methods of crystallizing an a-Si layer using a metal catalyst so that the a-Si layer can be crystallized at a lower temperature in a shorter amount of time compared to that of the SPC method. Such alternative crystallization methods using the metal catalyst may be classified into a MIC method and a MILC method. However, MIC and MILC methods have a contamination problem caused by a metal catalyst remaining in a poly-Si layer after a crystallization process. The contaminant problem leads to deterioration of the device characteristics of a TFT.

In order to solve the contamination problem caused by the metal catalyst, a method of fabricating a poly-Si layer through a crystallization process using a capping layer is proposed in Korean Patent Publication No. 2003-60403. Therein, an a-Si layer and a capping layer are deposited on a substrate, and a metal catalyst layer is formed thereon. Afterwards, the substrate is annealed or thermally treated using a laser beam so that a metal catalyst diffuses through the capping layer into the a-Si layer and forms a seed layer. Thus, the poly-Si layer is obtained using the seed layer. This method can prevent unnecessary metal contamination because the metal catalyst diffuses through the capping layer. However, even with the capping layer, a large amount of metal catalyst still remains in the poly-Si layer as metal contaminants.

### SUMMARY OF THE INVENTION

Aspects of the present invention include a method of fabricating a p-type thin film transistor (TFT), which includes crystallizing an amorphous silicon (a-Si) layer into a polycrystalline silicon (poly-Si) layer using a super grain silicon (SGS) method, patterning the crystallized layer, implanting gettering ions into source and drain regions of a semiconductor layer, and annealing the resultant structure to remove the very small amount of metal catalyst (e.g., Ni) remaining in the semiconductor layer, so that the amount of metal catalyst remaining in the semiconductor layer can be minimized to enhance device characteristics.

According to a first aspect of the present invention, there is provided a method of fabricating a TFT as set out in claim 1. Preferred features are set out in claims 2 to 22.

According to a second aspect of the present invention, there is provided a thin film transistor (TFT) as set out in claim 23. Preferred features are set out in claims 24 and 25.

Further embodiments and/or advantages of the invention will be set forth in part in the description which follows and, in part, will be obvious from the description, or may be learned by practice of the invention.

### BRIEF DESCRIPTION OF THE DRAWINGS

These and/or other aspects and advantages of the invention will become apparent and more readily appreciated from the following description of the embodiments taken in conjunction with the accompanying drawings of which:
FIGS. 1A through 1D are cross-sectional views illustrating a crystallization process according to an embodiment of the present invention;
FIGS. 2A and 2B are cross-sectional views illustrating a process of fabricating a thin film transistor (TFT) using a polycrystalline silicon (poly-Si) layer according to an embodiment of the present invention;
FIG. 3A is a cross-sectional view illustrating a process of forming source and drain regions and a channel region according to an embodiment of the invention by implanting p-type impurity ions, and FIG. 3B is a graph showing the changes of Rc and Rs according to different doses of the p-type impurity ions;
FIGS. 4A and 4C are cross-sectional views illustrating a process of removing a metal catalyst from a semiconductor layer according to an embodiment of the invention by implanting a gettering material and performing a third annealing process, and FIG. 4B is a graph showing the change in resistance according to different doses of the gettering materials;
FIGS. 5A and 5B are graphs showing Vg and I_{d} characteristics before and after the implantation of the gettering material;
FIG. 6 is a cross-sectional view illustrating a process of fabricating a TFT using a poly-Si layer according to an embodiment of the present invention; and
FIGS. 7A and 7B are cross-sectional views illustrating a process of fabricating a TFT according to an embodiment of the present invention.

### DETAILED DESCRIPTION OF THE EMBODIMENTS

Reference will now be made in detail to the embodiments of the present invention, examples of which are illustrated in the accompanying drawings, wherein like reference numerals refer to the like elements throughout. The embodiments are described below in order to explain the present invention by referring to the figures.

It will be understood that when a layer is referred to as being "on" another layer or substrate, it can be directly on the other layer or substrate or intervening layers may also be present. In the drawings, the thicknesses of layers and regions are exaggerated for clarity.

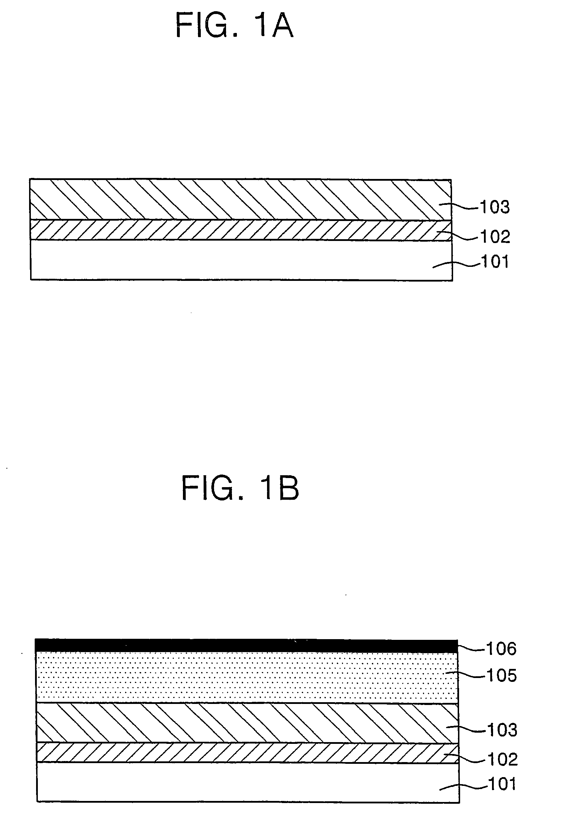

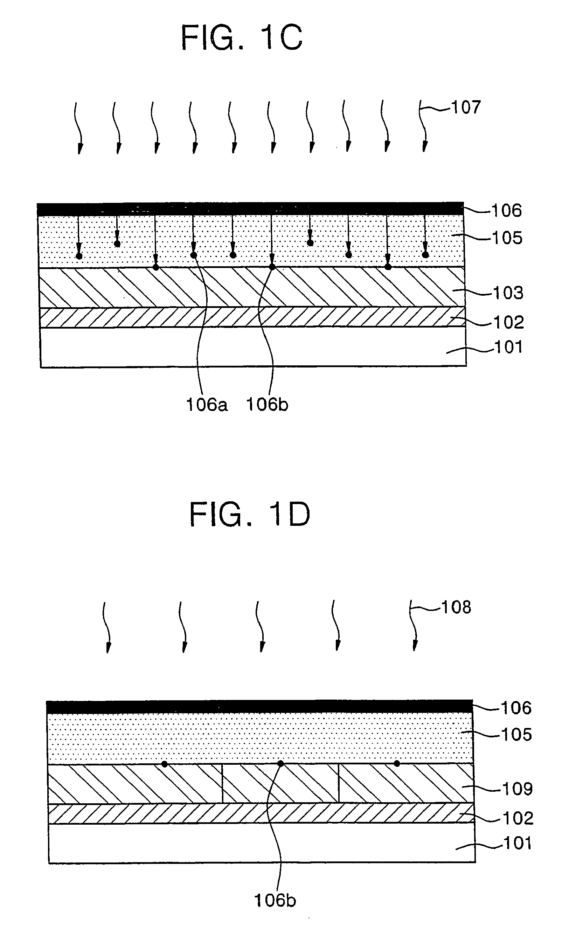

FIGS. 1A through 1D are cross-sectional views illustrating a crystallization process according to an embodiment of the present invention. Referring to FIG. 1A, a buffer layer 102 is formed on a substrate 101 using a chemical vapor deposition (CVD) process or a physical vapor deposition (PVD) process. While not restricted thereto, the substrate 101 may be a glass substrate or a plastic substrate. While not restricted thereto, the buffer layer 102 may be a silicon oxide layer, a silicon nitride layer, or a double layer of the silicon oxide layer and the silicon nitride layer. As shown, the buffer layer 102 facilitates crystallization of an amorphous silicon (a-Si) layer 103. Specifically, the buffer layer 102 may prevent diffusion of moisture or impurities generated from the substrate 101 or control a transfer rate of heat during a crystallization process.

Thereafter, the a-Si layer 103 is formed on the buffer layer 102. As shown, and while not restricted thereto, the a-Si layer 103 may be obtained using a CVD process or a PVD process. Also, a dehydrogenation process may be further carried out in order to lower the concentration of hydrogen in the a-Si layer during or after the formation of the a-Si layer 103.

FIG. 1 B is a cross-sectional view illustrating a process of forming a capping layer 105 and a metal catalyst layer 106 on the a-Si layer 103.

Referring to FIG. 1B, the capping layer 105 is formed on the a-Si layer 103. As shown, the capping layer 105 is formed of a silicon nitride layer through which a metal catalyst of the metal catalyst layer 106 can diffuse through during an annealing process. Alternatively, the capping layer 105 may be a double layer of a silicon nitride layer and a silicon oxide layer. The formation of the capping layer 105 may be performed using a CVD process or a PVD process. As shown, the capping layer 105 is formed to a thickness at or between 1 and 2000 Å. However, it is understood that other materials, processes, and thicknesses can be used to form the capping layer 105. Subsequently, the metal catalyst layer 106 is formed by depositing the metal catalyst on the capping layer 105. The metal catalyst may be at least one of Ni, Pd, Ti, Ag, Au, Al, Sn, Sb, Cu, Co, Mo, Tr, Ru, Rh, Cd, Pt, or any combination thereof. Preferably, though not required, nickel (Ni) is used as the metal catalyst.

In general, a metal induced crystallization (MIC) method or a metal induced lateral crystallization (MILC) method requires careful control of the thickness or density of the metal catalyst. This is because the metal catalyst may remain on the surface of a polycrystalline silicon (poly-Si) layer after the crystallization process and cause an increase in a leakage current of a TFT. In contrast, in various embodiments of the present invention, the metal catalyst layer 106 may be formed to a great thickness without requiring precise control of the thickness or density of the metal catalyst layer 106. Because the capping layer 105 filters the diffusing metal catalyst, only a very small amount of the metal catalyst contributes to crystallization. Accordingly, a large amount of the metal catalyst can neither pass through the capping layer 105 nor contribute to the crystallization.

FIG. 1C is a cross-sectional view illustrating a process of diffusing a metal catalyst through the capping layer 105 and moving the metal catalyst (of the metal catalyst layer 106) into (or onto) the surface of the a-Si layer 103 by applying a first annealing process to the substrate.

Referring to FIG. 1C, a first annealing process represented by 107 is performed on the substrate 101 including the buffer layer 102, the a-Si layer 103, the capping layer 105, and the metal catalyst layer 106 so that a portion of the metal catalyst of the metal catalyst layer 106 moves into the surface of the a-Si layer 103. Specifically, during the first annealing process 107, only a very small amount of the metal catalyst 106b diffuses into the surface of the a-Si layer 103, while a large amount of the metal catalyst 106a does not reach the a-Si layer 103 or pass through the capping layer 105. Therefore, the amount of the metal catalyst reaching the surface of the a-Si layer 103 depends on the diffusion blocking capability of the capping layer 105, which is closely related to the thickness of the capping layer 105. In other words, as the thickness of the capping layer 105 increases, the amount of the diffusing metal catalyst 106a, 106b decreases, and the size of crystal grains (not shown) increases. On the contrary, as the thickness of the capping layer 105 decreases, the amount of the diffusing metal catalyst 106b increases, and the size of crystal grains decreases.

As shown, the first annealing process 107 may be carried out for several seconds to several hours at a temperature at or between 200 and 800 °C to make the metal catalyst 106b diffuse into the surface of the a-Si layer 103. The first annealing process 107 may make use of at least one of a furnace process, a rapid thermal annealing (RTA) process, an ultraviolet (UV) process, a laser process, or any combination thereof.

FIG. 1D is a cross-sectional view illustrating a process of crystallizing the a-Si layer 103 into a poly-Si layer 109 due to the diffused metal catalyst 106b by applying a second annealing process to the substrate. Referring to FIG. 1D, a second annealing process represented by 108 is performed so that the a-Si layer (103 in FIG. 1C) is crystallized into a poly-Si layer 109 due to the metal catalyst 106b that diffused through the capping layer 105 into (or onto) the surface of the a-Si layer 103. Specifically, the metal catalyst 106b of the metal catalyst layer 106 combines with silicon of the a-Si layer 103, and forms a metal silicide. The metal silicide functions as a seed of a nucleus of crystallization and induces crystallization of the a-Si layer 103.

Accordingly, having more diffused metal catalyst 106b leads to having more metal silicide as seeds, and more crystal grains. However, having more crystal grains leads to sizes of the crystal grains being smaller. On the other hand, having less diffused metal catalyst 106b leads to having less metal silicide as seeds, and less crystal grains. However, having less crystal grains leads to sizes of the crystal grains being larger.

Thus, the crystallization method according to embodiments of the present invention include forming a capping layer 105 on an a-Si layer 103, forming a metal catalyst layer 106 on the capping layer 105, performing first and second annealing processes 107, 108 to diffuse a metal catalyst 106b, and crystallizing the a-Si layer 103 into a poly-Si layer 109 using the diffusing metal catalyst 106b. This method is called a "super grain silicon (SGS)" method.

By controlling the amount of metal silicide of the nucleus of the crystallization, the size of crystal grains of the poly-Si layer 109 can be controlled. Also, the size of the crystal grains depends on the metal catalyst 106b that contributes to the crystallization. As a result, the size of the crystal grains of the poly-Si layer 109 can be controlled by adjusting the diffusion blocking capability of the capping layer 105. In other words, the size of the crystal grains of the poly-Si layer 109 can be controlled by adjusting the thickness of the capping layer 105.

As illustrated in FIG. 1D, the second annealing process 108 is carried out without removing the capping layer 105 and the metal catalyst layer 106. However, in various embodiments, the second annealing process 108 may be performed on the resultant structure from which the capping layer 105 and the metal catalyst layer 106 have been removed. Alternatively, the metal catalyst layer 106 may be removed after the first annealing process (107 of FIG. 1 C), while the capping layer 105 may be removed after the second annealing process 108. In both cases, the second annealing process 108 may be performed at a temperature of about 400 to 1300 °C using a furnace process, an RTA process, a UV process, a laser process, or any combination thereof.

In various embodiments, by gettering, the remaining amount of metal catalyst 106b is removed from the bulk of the semiconductor layer 110 into boundaries of the crystal grains.

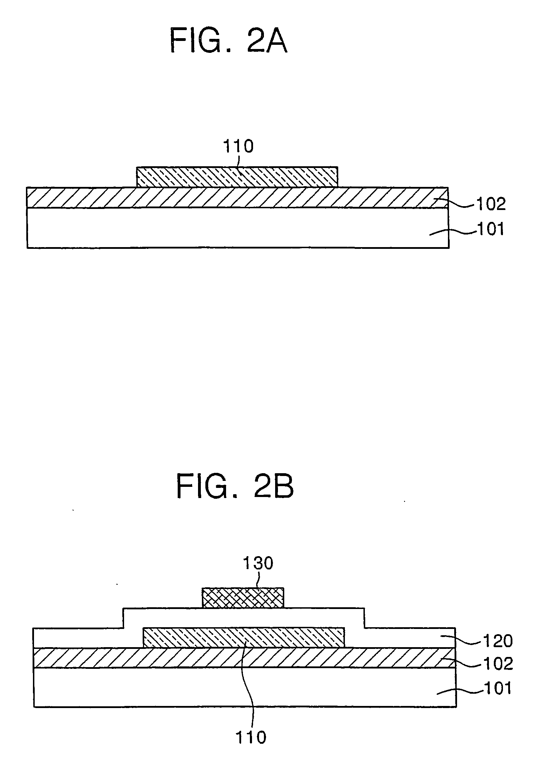

FIGS. 2A and 2B are cross-sectional views illustrating a process of fabricating a TFT using a poly-Si layer according to an embodiment of the present invention. Referring to FIG. 2A, the poly-Si layer (109 of FIG. 1 D) that is crystallized using an SGS method is patterned to form a semiconductor layer 110 on the substrate 101 having the buffer layer 102. Since only a very small amount of metal catalyst remains in the semiconductor layer 110 due to the capping layer 105, the semiconductor layer 110 has an excellent leakage current characteristic, compared to those of the other crystallization methods.

Referring to FIG. 2B, a gate insulating layer 120 is formed on the substrate 101 having the semiconductor layer 110. While not restricted thereto, the gate insulating layer 120 may be a silicon oxide layer, a silicon nitride layer, or a double layer of the silicon oxide layer and the silicon nitride layer. Subsequently, a metal layer (not shown) for a gate electrode 130 is formed on the gate insulating layer 120 and etched using photolithography and etching processes to form the gate electrode 130 in a predetermined portion corresponding to the semiconductor layer 110. As shown, and while not restricted thereto, the metal layer may be a single layer formed of aluminum or an aluminum alloy (such as aluminum-neodymium (Al-Nd)) or a double layer obtained by stacking an aluminum alloy on a chromium (Cr) or molybdenum (Mo) alloy.

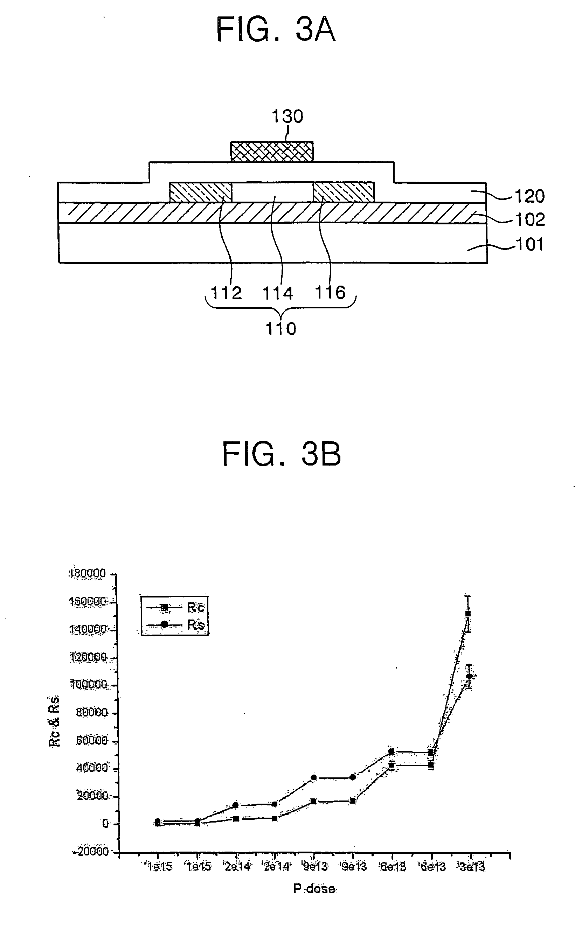

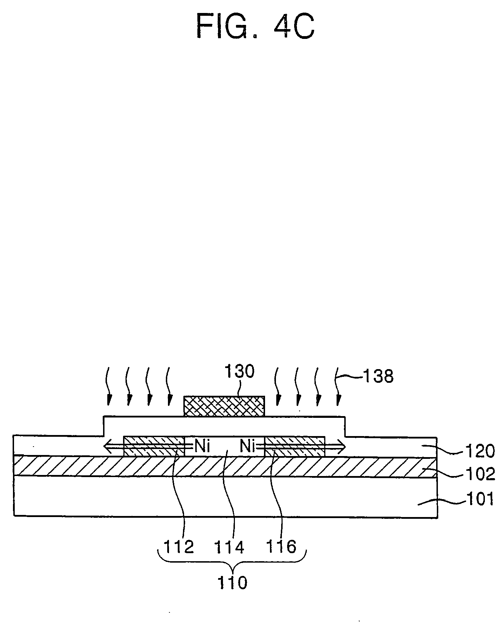

FIG. 3A is a cross-sectional view illustrating a process of forming source and drain regions 112, 116 and a channel region 114 by implanting p-type impurity ions. FIG. 3B is a graph showing the changes of Rc and Rs according to doses of p-type impurity ions.

Referring to FIG. 3A, conductive impurity ions (not shown) are implanted into the semiconductor layer 110 using the gate electrode 130 as a mask to form a source region 112 and a drain region 116. The impurity ions are p-type impurity ions to form a p-type TFT. While not required in all embodiments, the p-type impurity ions may be boron (B) ions, aluminum (Al) ions, gallium (Ga) ions, indium (In) ions, or any combination thereof. In embodiments of the present invention, boron ions may be used as impurity ions, though not required. Alternatively, the p-type impurity ions may be B₂Hₓ⁺, and/or BHₓ⁺ (where, X=1, 2, 3,...), or ions of an element of group III of Mendeleev's periodic table. In embodiments of the present invention, the impurity ions (such as boron ions) may be implanted at a dose of 6×10¹³/cm² to 5×10¹⁵/cm². When the boron ions are implanted at a dose of less than 6×10¹³/cm², leakage current may occur. On the other hand, when the boron ions are implanted at a dose of more than 5×10¹⁵/cm², resistance increases as shown in FIG. 3B, and leads to an increase in the driving voltage. Also, the boron ions are implanted at an acceleration voltage of 10 to 100 keV, and a projection range Rp (which is defined as a straight distance of a vertical average transfer path in the surface) is within about ±500 Å from an interface between the semiconductor layer 110 and the gate insulating layer 120.

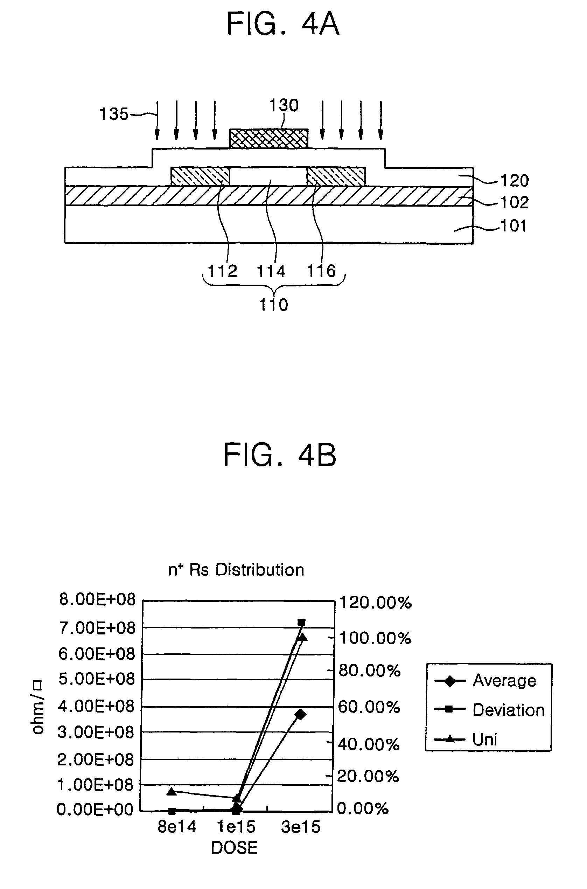

As shown, a region interposed between the source and drain regions 112 and 116, which is not implanted with impurity ions, functions as a channel region 114. However, the above described implantation of the impurity ions may be performed by forming a photoresist before the gate electrode 130 is formed. FIGS. 4A through 4C are cross-sectional views illustrating a process of removing a metal catalyst from the semiconductor layer by implanting a gettering material and performing a third annealing process.

Referring to FIG. 4A, a predetermined gettering material 135 is implanted into the source and drain regions 112 and 116 in order to remove the very small amount of metal catalyst remaining in the semiconductor layer 110. The gettering material 135 may be one of phosphorus (P), PHₓ⁺, and/or P₂Hₓ (where X=1, 2, 3, ...). Alternatively, the gettering material 135 may be ions of an element of group V of Mendeleev's periodic table. Preferably, though not required, the gettering material 135 (such as phosphorus ions) may be implanted at a dose of 1 ×10¹¹/cm² to 3×10¹⁵/cm². When the phosphorus ions are implanted at a dose of less than 1 ×10¹¹/cm², the amount of phosphorus ions implanted is deficient so that the small amount of metal catalyst (e.g., Ni) remaining cannot be sufficiently removed from the semiconductor layer 110. On the other hand, when the phosphorus ions are implanted at a dose of more than 3x10¹⁵/cm², resistance increases as shown in FIG. 4B. As shown, owing to the high atomic weight of phosphorus (P), even as the dose of the phosphorus ions increases, the resistance does not decrease at a typical annealing temperature. This electrical effect results from the fact that the phosphorus ions are not activated very well. Accordingly, the phosphorus ions are implanted at an acceleration voltage of 10 to 100 keV, and a projection range Rp, which is defined as a straight distance of a vertical average transfer path in the surface, is within about ±500 Å from an interface between the semiconductor layer 110 and the gate insulating layer 120.

Referring to FIG. 4C, a third annealing process 138 is subsequently carried out to remove the metal catalyst (e.g., Ni). The third annealing process 138 is performed at a temperature of at or between about 500 and 800 °C for 1 to 120 minutes. As a result, the small amount of metal catalyst (e.g., Ni) remaining in the semiconductor layer 110 is removed from the semiconductor layer 110 so that the p-type TFT can have excellent electrical characteristics.

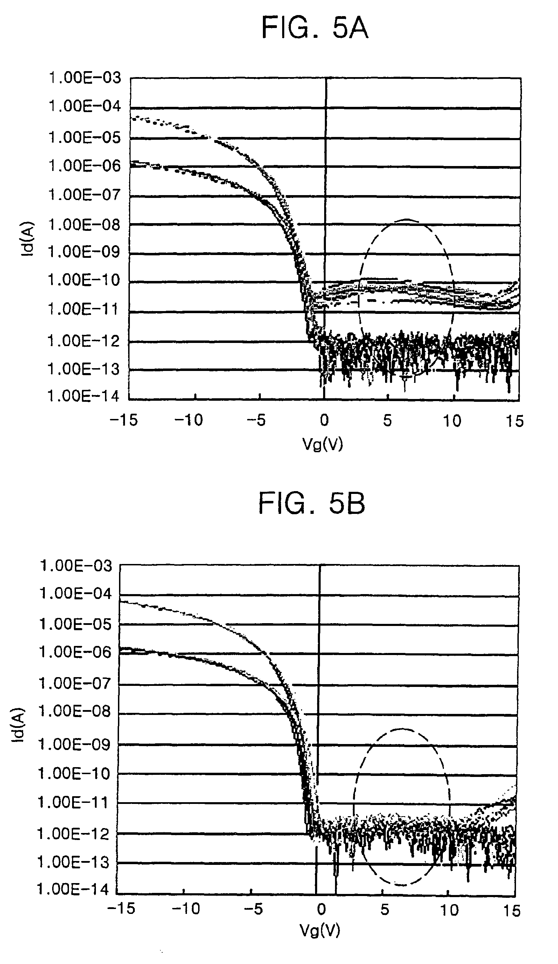

As described above, the gettering material 135 is implanted into the source and drain regions 112 and 116 and the third annealing process 138 is carried out. Accordingly, the characteristics of the p-type TFT can be enhanced as shown in FIGS. 5A and 5B. FIG. 5A is a graph showing gate voltages V_{g} and drain current I_{d} characteristics in a case where the gettering material is not implanted. FIG. 5B is a graph showing Vg and I_{d} characteristics in a case where phosphorus ions are implanted as the gettering material and the third annealing process 138 is performed to remove the metal catalyst (Ni). In comparing FIGS. 5A and 5B, it can be observed that when the gettering material 135 is implanted and the third annealing process 138 is performed, the characteristics of the p-type TFT are enhanced.

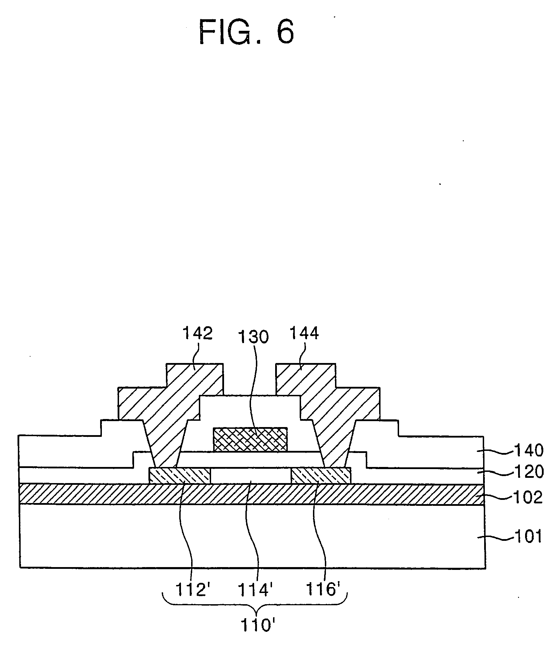

FIG. 6 is a cross-sectional view illustrating a process of fabricating a TFT using a poly-Si layer according to an embodiment of the present invention. Referring to FIG. 6, an interlayer insulating layer 140 is formed on the gate insulating layer 120 to protect an underlying structure including the gate electrode 130. Predetermined regions of the interlayer insulating layer 140 and the gate insulating layer 120 are etched to form contact holes. A source electrode 142 and a drain electrode 144 are formed to fill the contact holes, thereby completing a p-type TFT including a gettered semiconductor layer 110' with source and drain regions 112' and 116' and a channel region 114'.

In embodiments of the present invention, as the amount of metal catalyst that acts as seeds for crystal growth is controlled by the capping layer 105, the p-type TFT can include the semiconductor layer 110 containing a smaller amount of metal catalyst and larger polycrystalline grains than that in the related art methods using an MIC or MILC techniques.

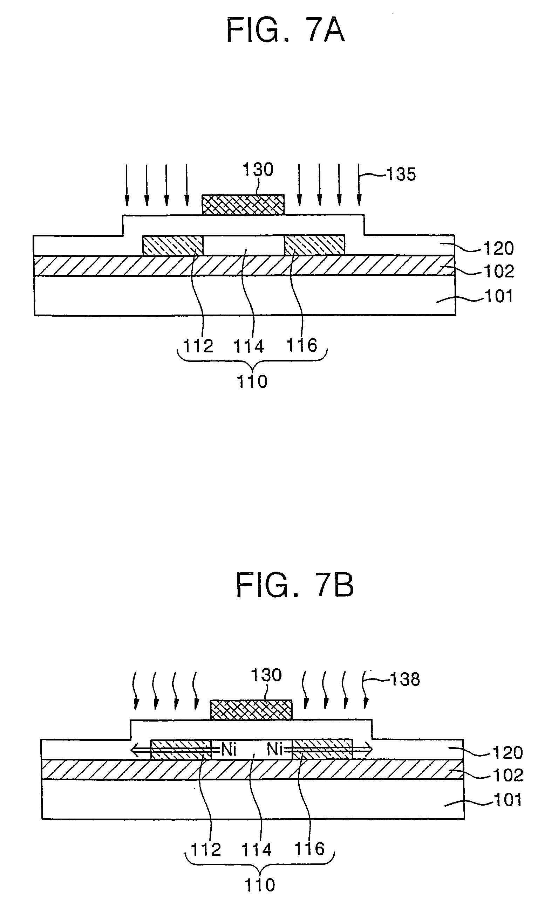

FIGS. 7A and 7B are cross-sectional views illustrating a process of fabricating a TFT according to an embodiment of the present invention. The embodiment of FIGS. 7A and 7B is performed under mostly the same process conditions (e.g., the dose of a gettering material and the implantation conditions such as temperature) as the embodiment of FIGS. 1A-1D, 2A and 2B, 3A and 3B, and 4A-4C, except for the order of fabrication of a p-type TFT. Accordingly, only the process of implanting the gettering material and the process of implanting p-type impurity ions will be described in detail.

Referring to FIG. 7A, a gettering material is implanted to remove the very small amount of metal catalyst remaining in the semiconductor layer 110. The gettering material 135 is implanted into portions of the semiconductor layer 110 where source and drain regions 112 and 116 are to be formed by implanting p-type impurity ions, such as boron ions later (namely, portions on both sides of a portion of the semiconductor layer 110 corresponding to a gate electrode 130). The gettering material may be one of phosphorus (P), PHₓ⁺, and/or P₂Hₓ (where, X=1, 2, 3, ...). Alternatively, the gettering material may be ions of an element of group V of Mendeleev's periodic table. Preferably, but not required, gettering material 135 (such as the phosphorus ions) is implanted at a dose of 1×10¹¹/cm² to 3×10¹⁵/cm². When the phosphorus ions are implanted at a dose of less than 1 × 10¹¹/cm², the amount of phosphorus ions implanted is deficient so that the small amount of metal catalyst (e.g., Ni) remaining in the semiconductor layer 110 cannot be sufficiently removed from the semiconductor layer 110. On the other hand, when the phosphorus ions are implanted at a dose of more than 3×10¹⁵/cm², resistance increases as shown in FIG. 4B. Owing to the high atomic weight of phosphorus (P), as the dose of the phosphorus ions increases, the resistance does not decrease at a typical annealing temperature. This electrical effect results from the fact that the phosphorus ions are not activated very well. Accordingly, the phosphorus ions are implanted at an acceleration voltage of 10 to 100 keV, and a projection range Rp, which is defined as a straight distance of a vertical average transfer path in the surface, is within about ±500 Å from an interface between the semiconductor layer 110 and the gate insulating layer 120.

Thereafter, conductive impurity ions are implanted using the gate electrode 130 as a mask, thereby forming a source region 112 and a drain region 116. The impurity ions are p-type impurity ions to form a p-type TFT. Here, the p-type impurity ions may be one of B, Al, Ga, In, or any combination thereof. As shown, boron ions may be used as impurity ions, thought not required. Alternatively, the p-type impurity ions may be B₂Hₓ⁺ and/or BHₓ⁺ (where, X=1, 2, 3,...) or ions of an element of group III of Mendeleev's periodic table. In embodiments of the present invention, the p-type impurity ions (such as the boron ions) may be implanted at a dose of 6×10¹³/cm² to 5×10¹⁵/cm². When the boron ions are implanted at a dose of less than 6×10¹³/cm², leakage current may occur. On the other hand, when the boron ions are implanted at a dose of more than 5x10¹⁵/cm², resistance increases as shown in FIG. 3B, and leads to a rise in a driving voltage. Also, the boron ions are implanted at an acceleration voltage of 10 to 100 keV, and a projection range Rp (which is defined as a straight distance of a vertical average transfer path in the surface) is within about ±500 Å from an interface between the semiconductor layer 110 and the gate insulating layer 120. In various embodiments, the gettering material 135 is an opposite type ion from that of the impurity ion implanted into the semiconductor layer 110. In other embodiments, the gettering material 135 may be an intrinsic material.

Here, a region interposed between the source and drain regions 112 and 116, which is not implanted with impurity ions, functions as a channel region 114. In various embodiments, the implantation of the impurity ions may be performed by forming photoresist before the gate electrode 130 is formed.

Referring to FIG. 7B, a third annealing process represented by 138 is subsequently carried out to remove the metal catalyst (not shown). The third annealing process 138 is performed at a temperature of at or between about 500 and 800 °C for 1 to 120 minutes. As a result, the small amount of metal catalyst (e.g., Ni) remaining in the semiconductor layer 110 is removed from the semiconductor layer 110 so that the p-type TFT can have excellent electrical characteristics.

Subsequently, an interlayer insulating layer (not shown) is formed on the gate insulating layer 120 to protect an underlying structure including the gate electrode 130. Predetermined regions of the interlayer insulating layer and the gate insulating layer 120 are etched to form contact holes (not shown). A source electrode (not shown) and a drain electrode (not shown) are formed to fill the contact holes, thereby completing the p-type TFT that includes a gettered semiconductor layer 110.

Also, in various embodiments, the TFT may be non p-type. That is, it may be an n-type TFT.

According to embodiments of the present invention, a gettering material is implanted into source and drain regions of a semiconductor layer and an annealing process is performed on the resultant structure to remove a small amount of metal catalyst (e.g., Ni) from the semiconductor layer, so that the amount of metal catalyst remaining in the semiconductor layer can be minimized. Accordingly, a leakage current and a driving voltage are reduced, and the device characteristics of the resulting p-type TFT are improved.

Although a few embodiments of the present invention have been shown and described, it will be appreciated by those skilled in the art that changes may be made in the embodiments without departing from the scope of the invention which is defined in the appended claims and their equivalents.

## Claims

1. A method of fabricating a thin film transistor (TFT), comprising:
providing a substrate,
forming an amorphous silicon layer on the substrate,
forming a capping layer on the amorphous silicon layer;
depositing a metal catalyst on the capping layer;
performing a first annealing process on the substrate to diffuse the metal catalyst through the capping layer into a surface of the amorphous silicon layer, and to crystallize the amorphous silicon layer to a polycrystalline silicon layer due to the diffused metal catalyst;
removing the capping layer;
patterning the polycrystalline silicon layer to form a semiconductor layer;
forming a gate insulating layer and a gate electrode on the substrate;
implanting first impurity ions into the semiconductor layer; and
implanting second impurity ions as gettering material into the semiconductor layer and performing a second annealing process to remove the metal catalyst.

2. A method according to claim 1, wherein the second impurity ions are of an opposite type of impurity ions from those of the first impurity ions.

3. A method according to claim 1 or 2, wherein the first impurity ions are p-type impurity ions.

4. A method according to any one of claims 1 to 3 wherein the second impurity ions are n-type ions.

5. A method according to any one of claims 1 to 4, wherein the second impurity ions are intrinsic impurity ions.

6. A method according to any one of claims 1 to 5, wherein the first impurity ions are implanted at a dose of 6×10¹³/cm² to 5x10¹⁵/cm², and the second impurity ions are implanted at a dose of 1×10¹¹/cm² to 3×10¹⁵/cm².

7. A method according to claim 3, wherein the p-type impurity ions are boron (B), B₂Hₓ⁺, BHₓ⁺ (where X=1, 2, 3, ...), or any combinations thereof.

8. A method according to claim 7, wherein the boron ions are implanted at an acceleration voltage in a range of from 10 to 100 keV.

9. A method according to claim 7 or 8, wherein the boron ions are implanted so that a projection range (Rp) is within about ±500 Å from an interface between the polycrystalline silicon layer and the gate insulating layer.

10. A method according to any preceding claim, wherein the gettering material is implanted into source and drain regions of the semiconductor layer.

11. A method according to any preceding claim, wherein the gettering material is an element of group V of Mendeleev's periodic table.

12. A method according to any one of claims 1 to 10, wherein the gettering material is phosphorus (P), PHₓ⁺, P₂Hₓ (where X=1, 2, 3, ...), or any combinations thereof.

13. A method according to claim 12, wherein the phosphorus ions are implanted at an acceleration voltage in a range of from 10 to 100 keV.

14. A method according to claim 12 or 13, wherein the phosphorus ions are implanted so that a projection range (Rp) is within about ±500 Å from an interface between the polycrystalline silicon layer and the gate insulating layer.

15. A method according to any preceding claim, wherein the second annealing process is performed at a temperature of at or between about 500 and 800 °C.

16. A method according to any preceding claim, wherein the second annealing process is performed for 1 to 120 minutes.

17. A method according to any preceding claim, wherein the capping layer is one of a silicon oxide layer, a silicon nitride layer, and a double layer of the silicon oxide layer and the silicon nitride layer.

18. A method according to any preceding claim, wherein the capping layer is formed to a thickness at or between 1 and 2000 Å.

19. A method according to any one of claims 10 to 18, wherein the gettering material is not implanted in a channel region positioned between the source and drain regions due to the gate electrode acting as a shield.

20. A method of fabricating a thin film transistor (TFT) according to any preceding claim wherein:
crystallizing the amorphous silicon layer on the substrate into a polycrystalline silicon layer involves using a metal catalyst in a super grain silicon (SGS) technique.

21. A method according to any preceding claim, wherein the implanting of the first impurity ions is performed prior to the implanting of the gettering material.

22. A method according to any one of claims 1 to 20, wherein the implanting of the gettering material is performed prior to the implanting of the first impurity ions.

23. A thin film transistor (TFT), comprising:
a substrate; and
a semiconductor layer on the substrate, the semiconductor layer containing first impurity ions and second impurity ions of an opposite type from that of the first impurity ions, wherein the semiconductor layer having been patterned from a polycrystalline silicon layer formed from crystallizing an amorphous silicon layer into the polycrystalline silicon layer using a metal catalyst in a super grain silicon (SGS) technique, the first impurity ions having been implanted into the semiconductor layer, the second impurity ions having been implanted into the semiconductor layer as gettering material, and the semiconductor layer having been subjected to an annealing process to remove the metal catalyst from the semiconductor layer.

24. A thin film transistor according to claim 23, wherein the first impurity ions have been implanted at a dose of 6×10¹³/cm² to 5×10¹⁵/cm², and the second impurity ions have been implanted at a dose of 1×10¹¹/cm² to 3×10¹⁵/cm².

25. The thin film transistor according to claim 23 or 24, wherein the first impurity ions are p-type impurity ions and the second impurity ions are n-type impurity ions.
